# FASCICULE DE BREVET EUROPEEN

(11) **EP 3 399 559 B1**
(45) Date de publication et mention de la délivrance du brevet: **26.02.2020**
(21) Numéro de dépôt: 18170304.2
(22) Date de dépôt: 02.05.2018
(51) Int. Cl.: H01L 33/00, H01L 33/06, H01L 33/08, H01L 33/32, H01L 33/04, H01L 33/50

(54) **DIODE ÉLECTROLUMINESCENTE COMPRENANT DES COUCHES DE CONVERSION EN LONGUEUR D'ONDE ET PROCÉDÉ DE RÉALISATION CORRESPONDANT**
LEUCHTDIODE MIT WELLENLÄNGEN-KONVERSIONSSCHICHTEN UND DEREN HERSTELLUNGSVERFAHREN
LIGHT-EMITTING DIODE COMPRISING WAVELENGTH CONVERSION LAYERS AND METHOD OF MANUFACTURING THE SAME

(30) Priorité: 02.05.2017 FR 1753842
(43) Date de publication de la demande: 07.11.2018
(73) Titulaire: Commissariat à l'énergie atomique et aux énergies alternatives, 75015 Paris (FR); THALES, 92400 Courbevoie (FR)
(72) Inventeur: ROBIN, Ivan-Christophe, 38000 GRENOBLE (FR)
(74) Mandataire: Brevalex

(56) Documents cités:
- FR-A1- 3 019 380
- US-A1- 2004 227 144
- US-A1- 2006 054 905
- US-A1- 2006 124 917
- US-A1- 2010 090 232
- US-A1- 2010 294 957
- US-A1- 2011 045 623
- US-A1- 2013 049 569
- US-A1- 2013 050 810
- US-A1- 2016 043 272

## Description

### DOMAINE TECHNIQUE ET ART ANTÉRIEUR

L'invention concerne le domaine des diodes électroluminescentes (appelées DEL ou LED) comprenant un ou plusieurs puits quantiques, ainsi que celui des dispositifs d'affichage comprenant de telles LEDs. L'invention concerne avantageusement une LED configurée pour émettre une lumière verte et/ou rouge.

Pour réaliser une LED émettant une lumière de couleur verte, ce qui correspond à une émission lumineuse comprise entre environ 500 nm et 580 nm, ou par exemple de l'ordre de 525 nm ou 530 nm, il est connu de former des puits quantiques avec des couches émissives d'InGaN chacune disposée entre deux couches barrières de GaN.

Une telle LED est toutefois peu efficace du fait de la dégradation de la qualité de l'InGaN réalisé quand la quantité d'indium augmente dans les couches émissives (en raison de l'augmentation de la différence de paramètre de maille entre l'InGaN et le GaN lorsque la proportion d'indium dans les couches émissives augmente).

Une manière de contourner ce problème est d'utiliser une LED comportant une première partie formant une structure d'émission configurée pour émettre une lumière de couleur bleu, par exemple à une longueur d'onde comprise entre environ 440 nm et 450 nm, couplée à une deuxième partie formant une structure de conversion en longueur d'onde de la lumière émise par la structure d'émission, et comportant des couches de conversion réalisant une conversion de la lumière bleue en une lumière verte. Une telle structure d'émission émettant une lumière bleue peut être réalisée à partir de puits quantiques dans lesquels les couches émissives comportent de l'InGaN avec un taux, ou une concentration, d'indium de l'ordre de 16%, et dans lesquels les couches barrières comportent du GaN. Les couches de conversion peuvent comporter également des puits quantiques. Les documents US 2013/049569 A1 et US 2011/045623 A1 divulguent de telles LEDs.

Cette approche est particulièrement intéressante dans le cas de dispositifs d'affichage par émission directe car elle permet potentiellement de convertir la lumière bleue sur de faibles épaisseurs. Par exemple, dans le cas d'un micro-écran doté de pixels réalisés avec un pas de l'ordre de 10 µm, la conversion de la lumière bleue en lumière verte est réalisée sur une épaisseur de l'ordre de 10 µm.

Pour réaliser de telles couches de conversion, il est possible d'utiliser des puits quantiques GaN/InGaN. Cependant, de telles couches de conversion se confrontent à deux problèmes :
- Tout d'abord, au sein de la structure de conversion, l'absorption de la lumière bleue émise par la structure d'émission est réalisée uniquement dans les couches émissives d'InGaN. Du fait que ces couches émissives ont une faible épaisseur, la lumière bleue est faiblement absorbée. En raison de cette faible absorption de la lumière reçue par les couches de conversion, pour convertir au moins 80 % de la lumière bleue incidente émise par la LED et reçue par les couches de conversion, il est nécessaire d'utiliser au moins 20 puits quantiques d'InGaN ayant chacun une épaisseur d'environ 3 nm. Avec un tel nombre de puits quantiques, la qualité de l'InGaN peut se dégrader, comme dans des couches épaisses d'InGaN. De plus, ce nombre important de niveaux confinés élargit la bande de longueurs d'ondes d'émission et induit également des problèmes de réabsorption de la lumière, émise depuis un premier puits, par un deuxième puits voisin au premier.
- De plus, pour émettre une lumière verte de longueur d'onde de l'ordre de 525 nm, le taux, ou la concentration, d'indium dans les couches émissives d'InGaN de la structure de conversion est égale à environ 25 %. Avec une telle concentration, il existe une forte différence de paramètre de maille entre l'InGaN des couches émissives et le GaN des couches barrières sur lesquelles les couches émissives sont réalisées. Les couches émissives réalisées sont donc de très mauvaise qualité.

Ainsi, avec de tels puits quantiques GaN/InGaN, les couches de conversion sont inefficaces, les efficacités de conversion (rapport du nombre de photons absorbés sur le nombre de photons réémis à la longueur d'onde souhaitée) obtenues étant inférieures à 20 %.

Des problèmes similaires se posent pour la réalisation d'une LED rouge, ce qui correspond à une émission lumineuse comprise entre environ 590 nm et 800 nm, comprenant des couches de conversion à puits quantiques GaN/InGaN destinées à convertir une lumière bleue en une lumière rouge, du fait que les concentrations en indium dans les couches émissives d'InGaN doivent dans ce cas être de l'ordre de 30 %, voire 40 %.

### EXPOSÉ DE L'INVENTION

Un but de la présente invention est de proposer une diode électroluminescente configurée pour émettre une lumière de couleur verte ou rouge ayant une bonne efficacité de conversion.

Pour cela, la présente invention propose une diode électroluminescente comprenant au moins :
- une structure d'émission d'une lumière à au moins une première longueur d'onde λ₁, comportant une jonction p-n dans laquelle est disposée une zone active incluant au moins un premier puits quantique formé par une première couche émissive comportant de l'In_{X1}Ga_{1-X1}N disposée entre deux premières barrières ;
- une structure de conversion configurée pour convertir la lumière destinée à être émise par la structure d'émission à au moins une deuxième longueur d'onde λ₂ différente de la première longueur d'onde λ₁, disposée sur la structure d'émission et comprenant au moins un deuxième puits quantique formé par une deuxième couche émissive d'In_{X2}Ga_{1-X2}N, disposée entre deux deuxièmes barrières comprenant chacune plusieurs premières couches d'absorption d'In_{X3}Ga_{1-X3}N séparées les unes des autres par au moins une première intercouche de GaN ;
dans laquelle les concentrations en indium X₁, X₂ et X₃ sont telles que 0 < X₁ < X₂ et Eg(In_{X2}Ga_{1-X2}N) < Eg(In_{X3}Ga_{1-X3}N) ≤ h.c/λ₁,
avec :
- Eg correspondant au gap, ou à la largeur de bande interdite ;
- h correspondant à la constante de Planck égale à environ 6,63.10⁻³⁴ J·s ;
- c correspondant à la célérité de la lumière, égale à 299 792 458 m/s.

Dans cette LED, la structure de conversion comporte des puits quantiques dans lesquels l'absorption de la lumière émise par la structure d'émission est réalisée non seulement par la ou les deuxièmes couches émissives, mais également par les couches d'absorption des deuxièmes barrières qui comportent de l'InGaN avec une composition en indium égale à X₃. La réalisation de telles deuxièmes barrières épaisses avec une composition en indium relativement importante est possible grâce à la présence des premières intercouches de GaN qui permettent d'obtenir une bonne épaisseur totale d'InGaN sans dégrader la qualité de ce semi-conducteur car lors d'une réalisation des deuxièmes barrières par épitaxie, ces premières intercouches réalisent une « réinitialisation » du paramètre de maille du matériau à faire croître, permettant la réalisation successive de plusieurs couches d'absorption d'InGaN sans dégradation de la qualité du semi-conducteur. Une couche d'InGaN sans intercouche de GaN et ayant une épaisseur équivalente à l'épaisseur des premières couches d'absorption se trouvant d'un côté de la deuxième couche émissive aurait une qualité bien inférieure à celle de ces premières couches d'absorption.

Par exemple, en réalisant la croissance d'une unique couche d'In_{0,14}Ga_{0,86}N d'épaisseur égale à 14 nm sur du GaN, la qualité de l'InGaN réalisé est médiocre car avec une telle concentration d'indium, cette épaisseur est trop importante pour obtenir de l'InGaN de bonne qualité qui permettrait de réaliser une bonne absorption lumineuse. Par contre, en réalisant la croissance d'une première couche d'In_{0,14}Ga_{0,86}N d'épaisseur égale à 7 nm sur du GaN, puis la réalisation d'une intercouche de GaN de quelques monocouches atomiques sur cette première couche d'In_{0,14}Ga_{0,86}N, et enfin la croissance d'une deuxième couche d'In_{0,14}Ga_{0,86}N d'épaisseur égale à 7 nm sur l'intercouche de GaN, la qualité du semi-conducteur de cette deuxième couche d'In_{0,14}Ga_{0,86}N est de bonne qualité équivalente à celle de la première couche d'In_{0,14}Ga_{0,86}N, du fait que les sept nanomètres d'In_{0,14}Ga_{0,86}N de la deuxième couche sont formés sur du GaN, contrairement aux sept derniers nanomètres de l'unique couche d'In_{0,14}Ga_{0,86}N d'épaisseur égale à 14 nm qui sont formés sur les sept premiers nanomètres de cette même couche.

En outre, la valeur basse de la concentration en indium X₃ des premières couches d'absorption est fonction de la concentration en indium X₁ dans la première couche émissive ainsi que de l'épaisseur du ou des premiers puits quantiques de la structure d'émission. Plus la concentration en indium X₁ est faible et plus le ou les premiers puits quantiques de la structure d'émission sont fins, plus la valeur de première longueur d'onde λ₁ est faible, ce qui permet d'avoir une concentration en indium X₃ dans les premières couches d'absorption qui soit également faible.

Il est possible d'avoir les concentrations en indium X₁ et X₃ telles que X₁ < X₃, ce qui permet d'améliorer l'absorption lumineuse par les premières couches d'absorption. En effet, il est possible d'avoir une énergie d'émission légèrement supérieure à l'énergie du gap Eg(In_{X1}Ga_{1-X1}N), c'est-à-dire avoir h.c/ λ₁ > Eg(In_{X1}Ga_{1-X1}N). Ceci est dû au confinement quantique car l'émission dans la structure d'émission s'effectue à une énergie légèrement supérieure à Eg(In_{X1}Ga_{1-X1}N). L'énergie h.c/λ₁ est d'autant supérieure à Eg(In_{X1}Ga_{1-X1}N) que les puits dans la structure d'émission sont fins.

Toutefois, il est possible d'avoir les concentrations en indium X₁ et X₃ telles que X₃ < X₁ du fait du confinement quantique dans les puits de composition X₁ dans la structure émettrice. Cela est avantageux pour ne pas avoir à faire croître des couches d'absorption avec une composition X₃ trop importante. Par exemple, de manière avantageuse, il est possible d'avoir X₁=0,15 et X₃=0,14 si les puits dans la structure émettrice ont une épaisseur inférieure à environ 2 nm.

Lorsque la première longueur d'onde λ₁ correspond à celle d'une lumière bleue, par exemple comprise entre environ 440 nm et 500 nm, il est possible que la concentration en indium X₃ soit telle que 0,14 ≤ X₃.

Avec de telles deuxièmes barrières, l'épaisseur totale de la structure de conversion peut donc être supérieure ou égale à environ 40 nm sans avoir à réaliser un grand nombre de puits quantiques, ce qui permet à la structure de conversion de réaliser une bonne absorption de la lumière émise par la structure d'émission, et donc d'avoir une bonne efficacité de conversion. En effet, grâce à l'absorption réalisée par les couches d'absorption, l'efficacité de conversion n'est pas limitée par le transfert des charges vers le ou les deuxièmes puits quantiques de la structure de conversion et dépend des paramètres utilisés pour les propriétés des matériaux en termes de taux de recombinaison Shockley Read Hall (SRH) et Auger.

L'épaisseur totale de la structure de conversion, c'est-à-dire l'épaisseur totale du ou des deuxièmes puits quantiques, peut être supérieure ou égale à environ 60 nm, ce qui permet l'obtention d'une meilleure absorption lumineuse par la structure de conversion. De manière avantageuse, cette épaisseur peut être supérieure ou égale à environ 100 nm, voire 200 nm.

La structure d'émission peut comporter un ou plusieurs premiers puits quantiques.

La structure de conversion peut comporter un nombre de deuxièmes puits quantiques compris entre 1 et 50. Ainsi, les réabsorptions de la lumière convertie par les autres puits quantiques sont évitées.

En ayant la condition X₁ < X₂, cela signifie que le gap de l'In_{X2}Ga_{1-X2}N, noté Eg(In_{X2}Ga_{1-X2}N), est inférieur à celui de l'In_{X1}Ga_{1-X1}N, noté Eg(In_{X1}Ga_{1-X1}N).

La première longueur d'onde est par exemple comprise entre environ 440 nm et 500 nm (spectre correspondant à une lumière bleue), et la deuxième longueur d'onde est par exemple comprise entre environ 500 nm et 580 nm (spectre correspondant à une lumière verte) ou entre environ 590 nm et 800 nm (spectre correspondant à une lumière rouge).

Chacune des premières barrières peut comporter une couche de GaN.

La concentration en indium X₁ peut être comprise entre environ 0,09 et 0,18, et par exemple égale à environ 0,15, et/ou la concentration en indium X₂ peut être telle que X₂ ≥ 0,22, et/ou la concentration en indium X₃ peut être telle que 0,08 ≤ X₃ ≤ 0,22 ou avantageusement 0,14 ≤ X₃ ≤ 0,18. De manière avantageuse, pour obtenir une conversion en une lumière verte, la concentration en indium X₂ peut être comprise entre environ 0,22 et 0,25, et par exemple égale à environ 0,25 pour obtenir une conversion à une deuxième longueur d'onde d'environ 530 nm. Pour obtenir une conversion en une lumière rouge, la concentration en indium X₂ peut être comprise entre environ 0,3 et 0,4, et par exemple égale à environ 0,35 pour obtenir une conversion à une deuxième longueur d'onde d'environ 620 nm.

Chaque première couche d'absorption qui n'est pas disposée contre la deuxième couche émissive peut avoir une épaisseur inférieure à 9 nm, et/ou l'épaisseur totale de la deuxième couche émissive et de deux premières couches d'absorption disposées contre la deuxième couche émissive peut être inférieure à 9 nm. Ainsi, au sein de la structure de conversion, il n'est pas réalisé de manière continue de l'InGaN sur une épaisseur supérieure à 9 nm, ce qui permet d'éviter toute dégradation de cet InGaN.

Chaque première intercouche de GaN peut avoir une épaisseur comprise entre 1 et 4 monocouches atomiques, et avantageusement comprise entre 1 et 2 monocouches atomiques.

Chacune des deuxièmes barrières peut comporter deux premières couches d'absorption et une première intercouche.

La structure de conversion peut comporter au moins un troisième puits quantique formé par une troisième couche émissive d'In_{X4}Ga_{1-X4}N, disposée entre deux troisièmes barrières comprenant chacune plusieurs deuxièmes couches d'absorption d'In_{X5}Ga_{1-X5}N séparées les unes des autres par au moins une deuxième intercouche de GaN, dans laquelle les concentrations en indium X₄ et X₅ sont telles que X₁ < X₄ et Eg(In_{X4}Ga_{1-X4}N) < Eg(In_{X5}Ga_{1-X5}N) ≤ h.c/λ₁, avec X₂ de valeur différente de celle de X₄. Une telle structure de conversion peut donc être polychrome, c'est-à-dire configurée pour convertir la lumière émise par la structure d'émission en au moins deux longueurs d'onde différente ou deux gammes de longueurs d'onde différentes.

La concentration en indium X₂ peut être comprise entre 0,22 et 0,25, et la concentration en indium X₄ peut être comprise entre 0,3 et 0,4.

L'invention porte également sur un procédé de réalisation d'au moins une diode électroluminescente, comprenant au moins :
- réalisation d'une structure d'émission d'une lumière à au moins une première longueur d'onde λ₁, comportant une jonction p-n dans laquelle est disposée une zone active incluant au moins un premier puits quantique formé par une première couche émissive comportant de l'In_{X1}Ga_{1-X1}N disposée entre deux premières barrières ;
- réalisation d'une structure de conversion configurée pour convertir la lumière destinée à être émise par la structure d'émission à au moins une deuxième longueur d'onde λ₂ différente de la première longueur d'onde λ₁, disposée sur la structure d'émission et comprenant au moins un deuxième puits quantique formé par une deuxième couche émissive d'In_{X2}Ga_{1-X2}N, disposée entre deux deuxièmes barrières comprenant chacune plusieurs premières couches d'absorption d'In_{X3}Ga_{1-X3}N séparées les unes des autres par au moins une première intercouche de GaN ;
dans lequel les concentrations en indium X₁, X₂ et X₃ sont telles que 0 < X₁ < X₂ et Eg(In_{X2}Ga_{1-X2}N) < Eg(In_{X3}Ga_{1-X3}N) ≤ h.c/λ₁,
avec :
- Eg correspondant au gap, ou à la largeur de bande interdite ;
- h correspondant à la constante de Planck égale à environ 6,63.10⁻³⁴ J·s ;
- c correspondant à la célérité de la lumière, égale à 299 792 458 m/s.

Les couches de la structure d'émission et de la structure de conversion peuvent être réalisées par épitaxie.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- la figure 1 représente une diode électroluminescente, objet de la présente invention, selon un mode de réalisation particulier;
- les figures 2 et 3 représentent des exemples de réalisation d'une structure de conversion d'une diode électroluminescente, objet de la présente invention.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

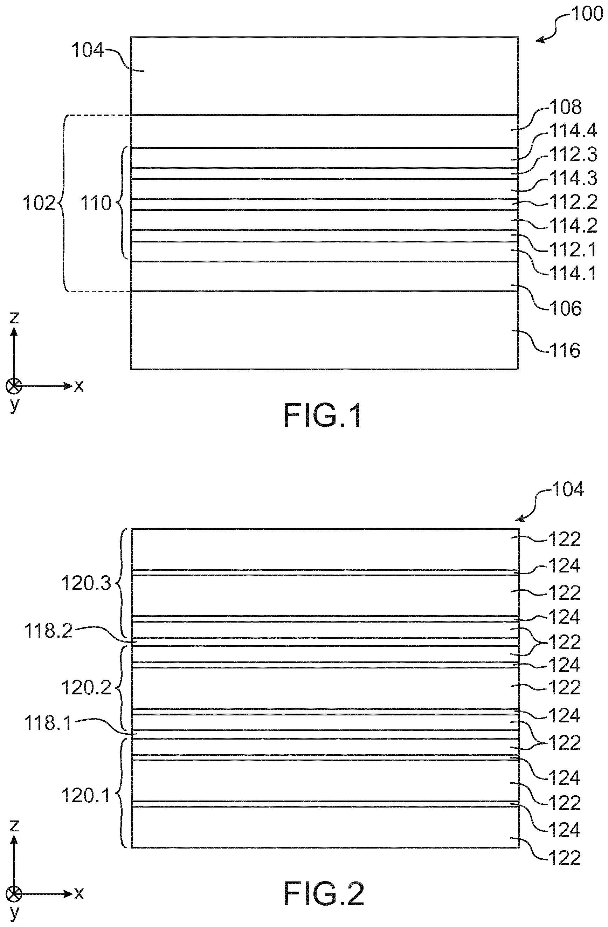

On se réfère tout d'abord à la figure 1 qui représente une diode électroluminescente, ou LED, 100 selon un mode de réalisation particulier.

Dans la notation In_{X}Ga_{1-X}N utilisée dans le présent document, X représente la composition en indium, ou concentration en indium, du matériau semi-conducteur, c'est-à-dire la proportion d'indium par rapport à la quantité totale d'indium et de gallium dans l'In_{X}Ga_{1-X}N. En outre, la caractéristique Eg(In_{X}Ga_{1-X}N) correspond au gap, ou largeur de bande interdite, du semi-conducteur In_{X}Ga_{1-X}N.

La LED 100 est formée de deux parties : une première partie formant une structure d'émission 102 configurée pour émettre une lumière comprenant au moins une première longueur d'onde λ₁, ou une première gamme de longueurs d'onde, et une deuxième partie formant une structure de conversion 104 disposée sur la structure d'émission 102 et configurée pour convertir la lumière émise par la structure d'émission 102 en une lumière comprenant au moins une deuxième longueur d'onde λ₂ différente de la première longueur d'onde, ou une deuxième gamme de longueurs d'onde différente de la première gamme de longueurs d'onde.

La structure d'émission 102 correspond à une structure classique de LED, et comporte une jonction p-n formée par une première couche 106 comprenant du GaN dopé n (GaN-n) avec une concentration de donneurs par exemple égale à environ 10¹⁹ donneurs/cm³ et une deuxième couche 108 comprenant du GaN dopé p (GaN-p) avec une concentration d'accepteurs par exemple égale à environ 10¹⁹ accepteurs/cm³. Ces deux couches 106 et 108 ont par exemple chacune une épaisseur (dimension selon l'axe Z représenté sur la figure 1) comprise entre environ 20 nm et 10 µm. De manière générale, la première couche 106 peut avoir une concentration de donneurs comprise entre environ 10¹⁷ et 10²⁰donneurs/cm³, et la deuxième couche 108 peut avoir une concentration d'accepteurs comprise entre environ 10¹⁵ et 10²⁰ accepteurs/cm³.

En variante, il est possible que la première couche 106 comporte de l'InGaN-n, avec une concentration en indium comprise par exemple entre 0 et environ 20 %. En outre, lorsque la concentration en indium dans l'InGaN de la première couche 106 est non nulle, la deuxième couche 108 peut comporter de l'InGaN-p. Dans ce cas, la concentration en indium dans l'InGaN de la deuxième couche 108 est avantageusement inférieure à la concentration en indium dans l'InGaN de la première couche 106, et par exemple comprise entre environ 0 % et 15 %.

La structure d'émission 102 comporte, entre les couches 106 et 108, une zone active 110 formée de semi-conducteur intrinsèque comprenant au moins un premier puits quantique formé par une première couche émissive 112 disposée entre deux premières barrières 114. Dans le mode de réalisation particulier décrit ici, la structure d'émission 102 comporte trois premières couches émissives 112, référencées 112.1, 112.2 et 112.3. De manière générale, la structure émissive 102 peut comporter n premières couches émissives 112, avec n nombre entier tel que n ≥ 1, et avantageusement tel que 3 ≤ n ≤ 6. De plus, les premières couches émissives 112 comportent de l'In_{X1}Ga_{1-X1}N. Le semi-conducteur des premières couches émissives 112 est non intentionnellement dopé (de concentration en donneurs résiduels par exemple telle que n_{nid} = 10¹⁷ donneurs/cm³). Enfin, chacune des premières couches émissives 112 a une épaisseur par exemple égale à environ 3 nm, ou comprise entre 1 nm et 5 nm.

Le taux d'indium de l'InGaN des premières couches émissives 112 peut être différent d'une couche à l'autre, la structure d'émission 102 étant dans ce cas configurée pour émettre selon des longueurs d'ondes différentes d'une première couche émissive 112 à l'autre. Mais de manière avantageuse, les concentrations en indium dans l'InGaN des premières couches émissives 112 sont similaires d'une première couche émissive à l'autre, la structure d'émission 102 étant dans ce cas configurée pour émettre une lumière monochromatique. Dans tous les cas, la valeur de la concentration en indium au sein de la ou des premières couches émissives 112 est choisie en fonction de la ou des longueurs d'ondes destinées à être émises.

Dans le mode de réalisation particulier décrit ici, les premières couches émissives 112 comportent de l'In_{0,16}Ga_{0,84}N (c'est-à-dire comprenant une proportion de 16 % d'indium pour 84 % de gallium), ou plus généralement de l'In_{X1}Ga_{1-X1}N avec X₁ compris entre environ 0,09 et 0,18. De telles premières couches émissives 112 permettent à la structure d'émission 102 d'émettre une lumière de couleur bleu.

La zone active 110 de la structure d'émission 102 comporte également des premières barrières 114 (au nombre de quatre dans la structure d'émission 102 représentée sur la figure 1, et référencées 114.1, 114.2, 114.3 et 114.4) comprenant par exemple du GaN non intentionnellement dopé (de concentration en donneurs résiduels par exemple telle que n_{nid} = 10¹⁷ donneurs/cm³), d'épaisseur par exemple égale à environ 8 nm. Deux des quatre premières barrières 114 sont interposées chacune entre deux premières couches émissives 112 consécutives, et les deux autres premières barrières 114 sont chacune interposée entre une des premières couches émissives 112 et l'une des couches 106 et 108. Ainsi, la première barrière 114.1 est disposée entre la première couche 106 et la première couche émissive 112.1. La première barrière 114.2 est disposée entre les premières couches émissives 112.1 et 112.2. La première barrière 114.3 est disposée entre les premières couches émissives 112.2 et 112.3. La première barrière 114.4 est disposée entre la première couche émissive 112.3 et la deuxième couche 108. Chaque première couche émissive 112 et les deux premières barrières 114 entre lesquelles se trouve cette première couche émissive 112 forment un premier puits quantique.

En variante, il est possible que les premières barrières 114 ne comportent pas du GaN mais de l'InGaN. Dans ce cas, les valeurs des concentrations en indium du semi-conducteur des premières barrières 114 sont inférieures à celles du semi-conducteur des premières couches émissives 112 et donc par exemple comprises entre environ 0,01 et 0,1.

De manière générale, la structure d'émission 102 qui comporte n premières couches émissives 112, avec n nombre entier supérieur ou égal à 1, comporte donc n+1 premières barrières 114. La zone active 110 est formée de l'empilement alterné des n premières couches émissives 112 et des n+1 premières barrières 114. Les couches 112 et 114 peuvent avoir des concentrations en donneurs résiduels comprises entre environ 10¹⁶ et 10²⁰ donneurs/cm³.

Les couches de la zone active 110 sont réalisées par épitaxie, par exemple MOCVD, sur une couche épaisse 116 de GaN formant le substrat de croissance.

En variante, la couche 116 peut comporter de l'InGaN. Dans ce cas, la structure d'émission 102 peut avantageusement correspondre à une structure entièrement formée d'InGaN, c'est-à-dire dont les couches 116, 106, 112, 114 et 108 comportent de l'InGaN.

En variante, une couche d'AIGaN dopée p peut être interposée entre la couche 108 et la zone active 110. Cette couche d'AIGaN peut comporter une concentration égale à environ 10¹⁹ accepteurs/cm³, une concentration d'aluminium comprise entre environ 5 % et 25 %, et une épaisseur comprise entre environ 5 nm et 100 nm. Une telle couche d'AIGaN permet de bloquer un courant d'électrons fuyant de la zone active vers le côté p de la jonction, c'est-à-dire la deuxième couche 108.

Un premier exemple de réalisation de la structure de conversion 104 de la LED 100 est représenté schématiquement sur la figure 2.

La structure de conversion 104 comporte un ou plusieurs deuxièmes puits quantiques qui sont destinés à réaliser une conversion de la ou des premières longueurs d'onde de la lumière émise par la structure d'émission 102 en une lumière comprenant une deuxième longueur d'onde ou une deuxième gamme de longueurs d'onde, différente de la première. Chacun des deuxièmes puits quantiques est formé par une deuxième couche émissive 118 disposée entre deux deuxièmes barrières 120. Dans le premier exemple de réalisation particulier décrit ici, la structure de conversion 104 comporte deux deuxièmes couches émissives 118, référencées 118.1 et 118.2, chacune disposée entre deux deuxièmes barrières 120, référencées 120.1, 120.2 et 120.3, formant ainsi deux deuxièmes puits quantiques. De manière générale, la structure de conversion 104 peut comporter m deuxièmes couches émissives 118, avec m nombre entier tel que m ≥ 1, et avantageusement tel que 1 ≤ m ≤ 5.

La deuxième barrière 120.1 est disposée entre la structure d'émission 102 et la deuxième couche émissive 118.1. La deuxième barrière 120.2 est disposée entre les deuxièmes couches émissives 118.1 et 118.2. La deuxième barrière 120.3 est disposée sur la deuxième couche émissive 118.2 et forme la face par laquelle la lumière dont la longueur d'onde a été convertie est destinée à être émise par la LED 100.

Les deuxièmes couches émissives 118 comportent de l'In_{X2}Ga_{1-X2}N. Dans le premier exemple de réalisation décrit ici, la concentration en indium X₂ de l'InGaN des deuxièmes couches émissives 118 est supérieure à environ 22 %, ici égale à environ 25 %. Ainsi, la lumière émise par la structure d'émission 102 est convertie en une lumière verte.

Le semi-conducteur des deuxièmes couches émissives 118 est non intentionnellement dopé (de concentration en donneurs résiduels par exemple telle que n_{nid} = 10¹⁷ donneurs/cm³). Enfin, chacune des deuxièmes couches émissives 118 a une épaisseur par exemple comprise entre environ 1 nm et 5 nm.

Contrairement aux premières barrières 114 qui sont chacune formées par une seule couche de matériau, chacune des deuxièmes barrières 120 est formée d'un empilement de plusieurs couches de matériaux distincts. Chacune des deuxièmes barrières 120 comporte plusieurs couches d'absorption d'In_{X3}Ga_{1-X3}N 122 séparées les unes des autres par au moins une intercouche de GaN 124. Sur l'exemple de réalisation de la figure 2, chacune des deuxièmes barrières 120 comporte trois couches d'absorption 122 séparées les unes des autres par deux intercouches 124. La concentration en indium X₃ de l'InGaN des couches d'absorption 122 est telle que Eg(In_{X2}Ga_{1-X2}N) < Eg(In_{X3}Ga_{1-X3}N) ≤ h.c/λ₁. Dans le cas d'une structure d'émission 102 émettant une lumière bleue, la concentration en indium X₃ de l'InGaN des couches d'absorption 122 peut être telle que 0,14 ≤ X₃ < X₂.

Contrairement aux couches barrières de GaN comme par exemple celles utilisées dans la structure d'émission 102, les deuxièmes barrières 120 comportent de l'InGaN avec une concentration en indium inférieure à celle de l'InGaN des deuxièmes couches émissives 118. L'InGaN des deuxièmes barrières 120 est également le matériau formant les couches d'absorption 122. Ainsi, l'absorption de la lumière émise par la structure d'émission 102 est absorbée non seulement par les deuxièmes couches émissives 118, mais également par les couches d'absorption 122 présentes dans les deuxièmes barrières 120.

En outre, l'épaisseur totale des deuxièmes puits quantiques, c'est-à-dire l'épaisseur totale de la structure de conversion 104 (dimension parallèle à l'axe Z de la figure 2) est ici supérieure ou égale à environ 40 nm, ce qui permet à la structure de conversion 104 de réaliser une bonne absorption de la lumière émise par la structure d'émission 102 pour réaliser une conversion de la ou des longueurs d'onde présentes dans cette lumière. Dans le mode de réalisation particulier décrit ici, étant donné les concentrations en indium X₁ et X₂ précédemment mentionnées, la LED 100 est configurée pour émettre une lumière verte grâce à la conversion de la lumière bleue émise par la structure d'émission 104 en lumière verte par la structure de conversion 104.

De manière avantageuse, l'épaisseur de la structure de conversion 104 est supérieure ou égale à environ 60 nm, ou supérieure ou égale à environ 100 nm, voire supérieure ou égale à environ 200 nm, ce qui augmente encore l'absorption réalisée par la structure de conversion 104 vis-à-vis de la lumière émise par la structure d'émission 102 du fait qu'une telle épaisseur implique la présence d'une épaisseur plus importante de matériau absorbant la lumière émise par la structure d'émission 102.

Cette épaisseur importante de la structure de conversion 104 est possible grâce à la présence des intercouches 124 de GaN qui, lors de la réalisation des deuxièmes barrières 120 par épitaxie, réalisent une relaxation du paramètre de maille et permettent donc d'obtenir une épaisseur totale d'InGaN bien supérieure à ce qu'il serait possible de réaliser en l'absence de ces intercouches de GaN.

En outre, afin que l'InGaN des couches d'absorption 122 et des deuxièmes couches émissives 118 soit une bonne qualité, l'épaisseur d'InGaN se trouvant entre deux intercouches 124 successives (c'est-à-dire l'épaisseur d'une des couches d'absorption 122, ou celle d'une des deuxièmes couches émissives 118 et des deux couches d'absorption 122 adjacentes) est de préférence inférieure à environ 9 nm. De plus, l'épaisseur de chaque intercouche 124 de GaN est par exemple comprise entre 1 et 4 monocouches atomiques, et de préférence comprise entre 1 et 2 monocouches atomiques.

Avec la structure de conversion 104 représentée sur la figure 2, ayant une épaisseur totale de 80 nm, et comportant deux deuxièmes couches émissives 118 d'In_{0,25}Ga_{0,75}N, des intercouches 124 de GaN (deux de chaque côté de chacune des deuxièmes couches émissives 118), et des couches d'absorption 122 d'In_{0,14}Ga_{0,86}N entre lesquelles sont disposées les intercouches 124, celle-ci peut absorber environ 80 % d'un flux incident de 100 W/cm². En réalisation une structure de conversion 104 ayant une épaisseur totale de 140 nm, et comportant deux deuxièmes couches émissives 118 d'In_{0,25}Ga_{0,75}N, des intercouches 124 de GaN (quatre de chaque côté de chacune des deuxièmes couches émissives 118), et des couches d'absorption 122 d'In_{0,14}Ga_{0,86}N entre lesquelles sont disposées les intercouches 124, cette structure peut absorber environ 97 % d'un flux incident de 100 W/cm².

Les efficacités de conversion obtenues sont par exemple comprises entre environ 76 % et 80 % en fonction du flux incident.

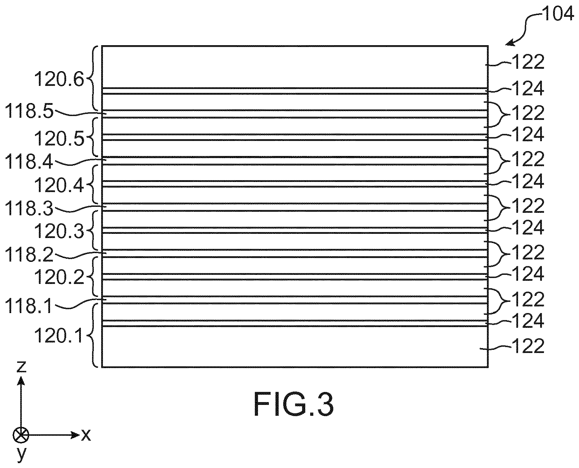

La figure 3 représente un deuxième exemple de réalisation de la structure de conversion 104. Dans ce deuxième exemple de réalisation, chaque deuxième barrière 120 comporte une seule intercouche 124 de GaN. Pour une épaisseur totale équivalente à celle de la structure de conversion 104 selon le premier exemple de réalisation, la structure de conversion 104 selon ce deuxième exemple de réalisation comporte un nombre plus important de puits quantiques, ici cinq. Les différentes variantes décrites précédemment en lien avec le premier exemple de réalisation peuvent s'appliquer également à ce deuxième exemple de réalisation.

Selon une variante de réalisation, la structure de conversion 104 peut être polychrome. Une telle structure comporte, en plus du ou des deuxièmes puits quantiques qui sont configurés pour convertir la lumière (comportant une première longueur d'onde ou une première gamme de longueurs d'onde) émise par la structure d'émission 102 en une lumière comportant une deuxième longueur d'onde ou une deuxième gamme de longueurs d'onde, par exemple de couleur verte, un ou plusieurs troisièmes puits quantiques configurés pour convertir la lumière émise par la structure d'émission 102 en une lumière comportant une troisième longueur d'onde ou une troisième gamme de longueurs d'onde, différente de la deuxième longueur d'onde ou de la deuxième gamme de longueurs d'onde. Cette différence de conversion entre les puits quantiques est obtenue en réalisant les couches émissives de ces puits avec de l'InGaN comportant des concentrations d'indium différentes.

Une telle structure de conversion 104 polychrome correspond par exemple à une structure similaire à celle représentée sur la figure 2, dans laquelle la concentration d'indium de l'InGaN de la couche émissive 118.1 est différente de celle de l'InGaN de la couche émissive 118.2. Ainsi, la couche émissive 118.1 et les barrières 120.1 et 120.2 peuvent former un puits quantique dans lequel l'In_{X2}Ga_{1-X2}N de la couche émissive 118.1 est tel que X₂ = 0,25 afin que ce puits quantique réalise une conversion à une longueur d'onde d'environ 530 nm (lumière verte), et la couche émissive 118.2 et les barrières 120.2 et 120.3 peuvent former un puits quantique dans lequel l'In_{X4}Ga_{1-X4}N de la couche émissive 118.2 est tel que X₄ = 0,35 afin que ce puits quantique réalise une conversion à une longueur d'onde d'environ 620 nm (lumière rouge).

De manière analogue, la structure de conversion 104 représentée sur la figure 3 peut correspondre à une structure de conversion polychrome, avec dans ce cas un ou plusieurs des puits quantiques de cette structure réalisant une conversion à une certaine longueur d'onde et le ou les autres puits quantiques réalisant une conversion à une autre longueur d'onde.

Il est également possible que la structure de conversion réalise une conversion de lumière polychrome selon plus de deux longueurs d'onde, ou plus de deux gammes de longueurs d'onde, lorsque cette structure comporte plus de deux puits quantiques.

Dans les exemples de réalisation et variantes décrits ci-dessus, la composition en indium dans l'InGaN des différentes couches est sensiblement constante au sein de cette ou chacune de ces couches. En variante, il est possible que la composition en indium d'une ou plusieurs des couches de la structure de conversion 104 et/ou de la structure d'émission 102 varie entre deux valeurs, selon la direction dans laquelle les différentes couches de la LED 100 sont empilées (c'est-à-dire parallèlement à l'axe Z). Ces variations sont toutefois telles que les conditions précédemment exposées sur les concentrations en indium X₁, X₂ et X₃ sont toujours vérifiées, c'est-à-dire telles que 0 < X₁ < X₂ et Eg(In_{X2}Ga_{1-X2}N) < Eg(In_{X3}Ga_{1-X3}N) ≤ h.c/λ₁.

A partir de la structure de la LED 100 telle que représentée sur la figure 1, des électrodes sont ensuite réalisées telles qu'elles soient reliées électriquement aux première et deuxième couches 106, 108.

La LED 100 précédemment décrite peut être réalisée sous la forme d'une diode planaire, c'est-à-dire sous la forme d'un empilement de couches formées par exemple par épitaxie sur un substrat, comme représenté sur la figure 1, les faces principales des différentes couches étant disposées parallèlement au plan du substrat (parallèle au plan (X,Y)). En variante, la LED 100 peut également être réalisée sous la forme d'un nanofil, axial ou radial, comme décrit par exemple dans le document WO 2014/154690 A1.

## Revendications

1. Diode électroluminescente (100) comprenant au moins :
- une structure d'émission (102) d'une lumière à au moins une première longueur d'onde λ₁, comportant une jonction p-n (106, 108) dans laquelle est disposée une zone active (110) incluant au moins un premier puits quantique formé par une première couche émissive (112) comportant de l'In_{X1}Ga_{1-X1}N disposée entre deux premières barrières (114) ;
- une structure de conversion (104) configurée pour convertir la lumière destinée à être émise par la structure d'émission (102) à au moins une deuxième longueur d'onde λ₂ différente de la première longueur d'onde λ₁, disposée sur la structure d'émission (102) et comprenant au moins un deuxième puits quantique formé par une deuxième couche émissive (118) d'In_{X2}Ga_{1-X2}N, disposée entre deux deuxièmes barrières (120) comprenant chacune plusieurs premières couches d'absorption (122) d'In_{X3}Ga_{1-X3}N séparées les unes des autres par au moins une première intercouche (124) de GaN ;
dans laquelle les concentrations en indium X₁, X₂ et X₃ sont telles que 0 < X₁ < X₂ et Eg(In_{X2}Ga_{1-X2}N) < Eg(In_{X3}Ga_{1-X3}N) ≤ h.c/λ₁,
avec :
- Eg correspondant au gap, ou à la largeur de bande interdite ;
- h correspondant à la constante de Planck égale à environ 6,63.10⁻³⁴ J·s ;
- c correspondant à la célérité de la lumière, égale à 299 792 458 m/s.

2. Diode électroluminescente (100) selon la revendication 1, dans laquelle l'épaisseur totale de la structure de conversion (104) est supérieure ou égale à 40 nm, ou supérieure ou égale à 60 nm.

3. Diode électroluminescente (100) selon l'une des revendications précédentes, dans laquelle les concentrations en indium X₁ et X₃ sont telles que X₁ < X₃.

4. Diode électroluminescente (100) selon l'une des revendications précédentes, dans laquelle la structure de conversion (104) comporte un nombre de deuxièmes puits quantiques compris entre 1 et 50.

5. Diode électroluminescente (100) selon l'une des revendications précédentes, dans laquelle chacune des premières barrières (114) comporte une couche de GaN.

6. Diode électroluminescente (100) selon l'une des revendications précédentes, dans laquelle la concentration en indium est comprise entre 0,09 et 0,18, et/ou dans laquelle la concentration en indium X₂ est telle que X₂ ≥ 0,22, et/ou dans laquelle la concentration en indium X₃ est telle que 0,08 ≤ X₃ ≤ 0,22.

7. Diode électroluminescente (100) selon l'une des revendications précédentes, dans laquelle chaque première couche d'absorption (122) qui n'est pas disposée contre la deuxième couche émissive (118) a une épaisseur inférieure à 9 nm, et/ou dans laquelle l'épaisseur totale de la deuxième couche émissive (118) et de deux premières couches d'absorption (122) disposées contre la deuxième couche émissive (118) est inférieure à 9 nm.

8. Diode électroluminescente (100) selon l'une des revendications précédentes, dans laquelle chaque première intercouche (124) a une épaisseur comprise entre 1 et 4 monocouches atomiques.

9. Diode électroluminescente (100) selon l'une des revendications précédentes, dans laquelle chacune des deuxièmes barrières (120) comporte deux premières couches d'absorption (122) et une première intercouche (124).

10. Diode électroluminescente (100) selon l'une des revendications précédentes, dans laquelle la structure de conversion (104) comporte au moins un troisième puits quantique formé par une troisième couche émissive (118) d'In_{X4}Ga_{1-X4}N, disposée entre deux troisièmes barrières (120) comprenant chacune plusieurs deuxièmes couches d'absorption (122) d'In_{X5}Ga_{1-X5}N séparées les unes des autres par au moins une deuxième intercouche (124) de GaN, dans laquelle les concentrations en indium X₄ et X₅ sont telles que X₁ < X₄ et Eg(In_{X4}Ga_{1-X4}N) < Eg(In_{X5}Ga_{1-X5}N) ≤ h.c/λ₁, avec X₂ de valeur différente de celle de X₄.

11. Diode électroluminescente (100) selon la revendication 10, dans laquelle la concentration en indium X₂ est comprise entre 0,22 et 0,25, et dans laquelle la concentration en indium X₄ est comprise entre 0,3 et 0,4.

12. Procédé de réalisation d'au moins une diode électroluminescente (100), comprenant au moins :
- réalisation d'une structure d'émission (102) d'une lumière à au moins une première longueur d'onde λ₁, comportant une jonction p-n (106, 108) dans laquelle est disposée une zone active (110) incluant au moins un premier puits quantique formé par une première couche émissive (112) comportant de l'In_{X1}Ga_{1-X1}N disposée entre deux premières barrières (114) ;
- réalisation d'une structure de conversion (104) configurée pour convertir la lumière destinée à être émise par la structure d'émission (102) à au moins une deuxième longueur d'onde λ₂ différente de la première longueur d'onde λ₁, disposée sur la structure d'émission (102) et comprenant au moins un deuxième puits quantique formé par une deuxième couche émissive (118) d'In_{X2}Ga_{1-X2}N, disposée entre deux deuxièmes barrières (120) comprenant chacune plusieurs premières couches d'absorption (122) d'In_{X3}Ga_{1-X3}N séparées les unes des autres par au moins une première intercouche (124) de GaN ;
dans lequel les concentrations en indium X₁, X₂ et X₃ sont telles que 0 < X₁ < X₂ et Eg(In_{X2}Ga_{1-X2}N) < Eg(In_{X3}Ga_{1-X3}N) ≤ h.c/λ₁,
avec :
- Eg correspondant au gap, ou à la largeur de bande interdite ;
- h correspondant à la constante de Planck égale à environ 6,63.10⁻³⁴ J·s ;
- c correspondant à la célérité de la lumière, égale à 299 792 458 m/s.

13. Procédé de réalisation selon la revendication 12, dans lequel les couches (106, 108, 112, 114, 118, 122, 124) de la structure d'émission (102) et de la structure de conversion (104) sont réalisées par épitaxie.

## Patentansprüche

1. Leuchtdiode (100), umfassend mindestens:
- eine Struktur (102) zur Emission eines Lichts mit mindestens einer ersten Wellenlänge λ₁, umfassend einen p-n-Übergang (106, 108), in welcher ein aktives Gebiet (110) angeordnet ist, das mindestens eine erste Quantensenke aufweist, die aus einer ersten emittierenden Schicht (112) gebildet ist, umfassend In_{X1}Ga_{1-X1}N, die zwischen zwei ersten Sperren (114) angeordnet ist;
- eine Konversionsstruktur (104), welche dazu ausgelegt ist, um das Licht, das dazu bestimmt ist, von der Emissionsstruktur (102) emittiert zu werden, in mindestens eine zweite Wellenlänge λ₂ zu konvertieren, die von der ersten Wellenlänge λ₁ verschieden ist, welche auf der Emissionsstruktur (102) angeordnet ist und mindestens eine zweite Quantensenke umfasst, die aus einer zweiten emittierenden Schicht (118) aus In_{X2}Ga_{1-X2}N gebildet ist, die zwischen zwei zweiten Sperren (120) angeordnet ist, jeweils umfassend mehrere Absorptionsschichten (122) aus In_{X3}Ga_{1-X3}N, die durch mindestens eine Zwischenschicht (124) aus GaN voneinander getrennt sind;
wobei die Konzentrationen von Indium X₁, X₂ und X₃ derart sind, dass 0 < X₁ < X₂ und Eg (In_{X2}Ga_{1-X2}N) < Eg(In_{X3}Ga_{1-X3}N) ≤ h.c/λ₁,
wobei:
- Eg dem Spalt oder der Breite der Bandlücke entspricht;
- h der Planck-Konstante gleich ungefähr 6,63.10⁻³⁴ J·s entspricht;
- c der Lichtgeschwindigkeit gleich 299 792 458 m/s entspricht.

2. Leuchtdiode (100) nach Anspruch 1,
wobei die Gesamtdicke der Konversionsstruktur (104) größer oder gleich 40 nm oder größer oder gleich 60 nm ist.

3. Leuchtdiode (100) nach einem der vorhergehenden Ansprüche,
wobei die Konzentrationen von Indium X₁ und X₃ derart sind, dass X₁ < X₃.

4. Leuchtdiode (100) nach einem der vorhergehenden Ansprüche,
wobei die Konversionsstruktur (104) eine Anzahl von zweiten Quantensenken zwischen 1 und 50 umfasst.

5. Leuchtdiode (100) nach einem der vorhergehenden Ansprüche,
wobei jede der Sperren (114) eine Schicht aus GaN umfasst.

6. Leuchtdiode (100) nach einem der vorhergehenden Ansprüche,
wobei die Konzentrationen von Indium X₁ zwischen 0,09 und 0,18 beträgt, und/oder wobei die Konzentration von Indium X₂ derart ist, dass X₂ ≥ 0,22, und/oder wobei die Konzentration von Indium X₃ derart ist, dass 0,08 ≤ X₃ ≤ 0,22.

7. Leuchtdiode (100) nach einem der vorhergehenden Ansprüche,
wobei jede erste Absorptionsschicht (122), die nicht gegen die zweite emittierende Schicht (118) angeordnet ist, eine Dicke von weniger als 9 nm aufweist, und/oder wobei die Gesamtdicke der zweiten emittierende Schicht (118) und von zwei ersten Absorptionsschichten (122), die gegen die zweite emittierende Schicht (118) angeordnet sind, kleiner als 9 nm ist.

8. Leuchtdiode (100) nach einem der vorhergehenden Ansprüche,
wobei jede erste Zwischenschicht (124) eine Dicke zwischen 1 und 4 atomaren Monoschichten aufweist.

9. Leuchtdiode (100) nach einem der vorhergehenden Ansprüche,
wobei jede der zweiten Sperren (120) zwei erste Absorptionsschichten (122) und eine erste Zwischenschicht (124) umfasst.

10. Leuchtdiode (100) nach einem der vorhergehenden Ansprüche,
wobei die Konversionsstruktur (104) mindestens eine dritte Quantensenke umfasst, die aus einer dritten emittierenden Schicht (118) aus In_{X4}Ga_{1-X4}N gebildet ist, welche zwischen zwei dritten Sperren (120) angeordnet ist, umfassend jeweils mehrere zweite Absorptionsschichten (122) aus In_{X5}Ga_{1-X5}N, die durch mindestens eine zweite Zwischenschicht (124) aus GaN voneinander getrennt sind, wobei die Konzentrationen von Indium X₄ und X₅ derart sind, dass X₁ < X₄ und Eg (In_{X4}Ga_{1-X4}N) < Eg (In_{X5}Ga_{1-X5}N) ≤ h.c/λ₁, wobei X₂ einen anderen Wert aufweist als jenen von X₄.

11. Leuchtdiode (100) nach Anspruch 10,
wobei die Konzentration von Indium X₂ zwischen 0,22 und 0,25 beträgt, und wobei die Konzentration von Indium X₄ zwischen 0,3 und 0,4 beträgt.

12. Verfahren zur Herstellung mindestens einer Leuchtdiode (100), umfassend mindestens:
- Herstellen einer Struktur (102) zur Emission eines Lichts mit mindestens einer ersten Wellenlänge λ₁, umfassend einen p-n-Übergang (106, 108), in welcher ein aktives Gebiet (110) angeordnet ist, das mindestens eine erste Quantensenke aufweist, die aus einer ersten emittierenden Schicht (112) gebildet ist, umfassend In_{X1}Ga_{1-X1}N, die zwischen zwei ersten Sperren (114) angeordnet ist;
- Herstellen einer Konversionsstruktur (104), welche dazu ausgelegt ist, um das Licht, das dazu bestimmt ist, von der Emissionsstruktur (102) emittiert zu werden, in mindestens eine zweite Wellenlänge λ₂ zu konvertieren, die von der ersten Wellenlänge λ₁ verschieden ist, welche auf der Emissionsstruktur (102) angeordnet ist und mindestens eine zweite Quantensenke umfasst, die aus einer zweiten emittierenden Schicht (118) aus In_{X2}Ga_{1-X2}N gebildet ist, die zwischen zwei zweiten Sperren (120) angeordnet ist, jeweils umfassend mehrere erste Absorptionsschichten (122) aus In_{X3}Ga_{1-X3}N, die durch mindestens eine erste Zwischenschicht (124) aus GaN voneinander getrennt sind;
wobei die Konzentrationen von Indium X₁, X₂ und X₃ derart sind, dass 0 < X₁ < X₂ und Eg (In_{X2}Ga_{1-X2}N) < Eg(In_{X3}Ga_{1-X3}N) ≤ h.c/λ₁,
wobei:
- Eg dem Spalt oder der Breite der Bandlücke entspricht;
- h der Planck-Konstante gleich ungefähr 6,63.10⁻³⁴ J·s entspricht;
- c der Lichtgeschwindigkeit gleich 299 792 458 m/s entspricht.

13. Herstellungsverfahren nach Anspruch 12,
wobei die Schichten (106, 108, 112, 114, 118, 122, 124) der Emissionsstruktur (102) und der Konversionsstruktur (104) durch Epitaxie hergestellt werden.

## Claims

1. Light emitting diode (100) including at least:
- a structure (102) for emitting light at at least one first wavelength λ₁, comprising a p-n junction (106, 108) in which is arranged an active zone (110) including at least one first quantum well formed by a first emissive layer (112) comprising In_{X1}Ga_{1-X1}N arranged between two first barriers (114);
- a conversion structure (104) configured for converting the light intended to be emitted by the emission structure (102) into at least one second wavelength λ₂ different to the first wavelength λ₁, arranged on the emission structure (102) and including at least one second quantum well formed by a second In_{X2}Ga_{1-X2}N emissive layer (118), arranged between two second barriers (120) each including several first In_{X3}Ga_{1-X3}N absorption layers (122) separated from each other by at least one first GaN interlayer (124);
in which the indium concentrations X₁, X₂ and X₃ are such that 0 < X₁ < X₂ and Eg(In_{X2}Ga_{1-X2}N) < Eg(In_{X3}Ga_{1-X3}N) ≤ h.c/λ₁,
with:
- Eg corresponding to the gap, or to the forbidden energy gap;
- h corresponding to the Planck's constant equal to around 6.63.10⁻³⁴ J·s;
- c corresponding to the speed of light, equal to 299,792,458 m/s.

2. Light emitting diode (100) according to claim 1, in which the total thickness of the conversion structure (104) is greater than or equal to 40 nm, or greater than or equal to 60 nm.

3. Light emitting diode (100) according to one of previous claims, in which the indium concentrations X₁ and X₃ are such that X₁ < X₃.

4. Light emitting diode (100) according to one of previous claims, in which the conversion structure (104) comprises a number of second quantum wells between 1 and 50.

5. Light emitting diode (100) according to one of previous claims, in which each of the first barriers (114) comprises a GaN layer.

6. Light emitting diode (100) according to one of previous claims, in which the indium concentration X₁ is between 0.09 and 0.18, and/or in which the indium concentration X₂ is such that X₂ ≥ 0.22, and/or in which the indium concentration X₃ is such that 0.08 ≤ X₃ ≤ 0.22.

7. Light emitting diode (100) according to one of previous claims, in which each first absorption layer (122) which is not arranged against the second emissive layer (118) has a thickness less than 9 nm, and/or in which the total thickness of the second emissive layer (118) and of two first absorption layers (122) arranged against the second emissive layer (118) is less than 9 nm.

8. Light emitting diode (100) according to one of previous claims, in which each first interlayer (124) has a thickness between 1 and 4 atomic monolayers.

9. Light emitting diode (100) according to one of previous claims, in which each of the second barriers (120) comprises two first absorption layers (122) and a first interlayer (124).

10. Light emitting diode (100) according to one of previous claims, in which the conversion structure (104) comprises at least one third quantum well formed by a third In_{X4}Ga_{1-X4}N emissive layer (118), arranged between two third barriers (120) each including several second In_{X5}Ga_{1-X5}N absorption layers (122) separated from each other by at least one second GaN interlayer (124), in which the indium concentrations X₄ and X₅ are such that X₁ < X₄ and Eg(In_{X4}Ga_{1-X4}N) < Eg(In_{X5}Ga_{1-X5}N) ≤ h.c/λ₁, with X₂ of value different to that of X₄.

11. Light emitting diode (100) according to claim 10, in which the indium concentration X₂ is between 0.22 and 0.25, and in which the indium concentration X₄ is between 0.3 and 0.4.

12. Method for producing at least one light emitting diode (100), including at least:
- production of a structure (102) for emitting light at at least one first wavelength λ₁, comprising a p-n junction (106, 108) in which is arranged an active zone (110) including at least one first quantum well formed by a first emissive layer (112) comprising In_{X1}Ga_{1-X1}N arranged between two first barriers (114);
- production of a conversion structure (104) configured for converting the light intended to be emitted by the emission structure (102) into at least one second wavelength λ₂ different to the first wavelength λ₁, arranged on the emission structure (102) and including at least one second quantum well formed by a second In_{X2}Ga_{1-X2}N emissive layer (118), arranged between two second barriers (120) each including several first In_{X3}Ga_{1-X3}N absorption layers (122) separated from each other by at least one first GaN interlayer (124);
in which the indium concentrations X₁, X₂ and X₃ are such that 0 < X₁ < X₂ and Eg(In_{X2}Ga_{1-X2}N) < Eg(In_{X3}Ga_{1-X3}N) ≤ h.c/λ₁,
with:
- Eg corresponding to the gap, or to the forbidden energy gap;
- h corresponding to the Planck's constant equal to around 6.63.10⁻³⁴ J·s;
- c corresponding to the speed of light, equal to 299,792,458 m/s.

13. Production method according to claim 12, in which the layers (106, 108, 112, 114, 118, 122, 124) of the emission structure (102) and the conversion structure (104) are produced by epitaxy.
